# EUROPEAN PATENT APPLICATION

(11) **EP 4 734 703 A1**
(43) Date of publication of application: **29.04.2026**
(21) Application number: 23946325.0
(22) Date of filing: 18.08.2023
(51) Int. Cl.: H10F 19/00, H10F 77/20

(54) **BACK-CONTACT SOLAR CELL, BATTERY ASSEMBLY AND PHOTOVOLTAIC SYSTEM**

(30) Priority: 27.07.2023 CN 202310934646
(71) Applicant: Zhejiang Aiko Solar Energy Technology Co., Ltd., Yiwu, Jinhua Zhejiang 322000 (CN); Guangdong Aiko Solar Energy Technology Co., Ltd., Foshan, Guangdong 528000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN)
(72) Inventor: KANG, Jianfeng, Jinhua, Zhejiang 322000 (CN); PAN, Jian, Jinhua, Zhejiang 322000 (CN); CHEN, Yunwu, Jinhua, Zhejiang 322000 (CN); JIANG, Pengxiang, Jinhua, Zhejiang 322000 (CN); XU, Fengxin, Jinhua, Zhejiang 322000 (CN); YIN, Wenjie, Jinhua, Zhejiang 322000 (CN); CHEN, Gang, Jinhua, Zhejiang 322000 (CN)
(74) Representative: EP&C
(86) International application number: PCT/CN2023/113866
(87) International publication number: WO 2025/020244

(57) **Abstract**

Disclosed are a back-contact solar cell, a cell assembly, and a photovoltaic system. First busbars (23) of a back-contact solar cell (100) are in contact with first finger pre-plated layers (211), and second busbars (24) are in contact with second finger pre-plated layers (221); a first conductive connector (30) and a second conductive connector (40) are respectively arranged on two ends of each first busbar (23) and two ends of each second busbar (24); and the first conductive connector (30) is connected to the ends of all the first busbars (23) facing away from the second conductive connector (40), and the second conductive connector (40) is connected to the ends of all the second busbars (24) facing away from the first conductive connector (30). In this way, when the first finger electroplated layers (212) and the second finger electroplated layers (222) are formed, the first finger electroplated layers (212) and the second finger electroplated layers (222) may be respectively formed on all the first finger pre-plated layers (211) and all the second finger pre-plated layers (221) by means of simply connecting a cathode of an electroplating device to the first conductive connector (30) and the second conductive connector (40), thereby effectively simplifying the electroplating process, and improving the electroplating efficiency.

## Description

The present disclosure claims priority to Chinese Patent Application No. 202310934646.6, filed on July 27, 2023 and entitled "Back-Contact Solar Cell, Cell Assembly, and Photovoltaic System", the disclosure of which is hereby incorporated by reference in its entirety.

### Technical Field

The present disclosure relates to the technical field of solar batteries, and in particular, to a back-contact solar cell, a cell assembly, and a photovoltaic system

### Background

A back-contact solar cell is a solar cell in which both P-regions and N-regions are arranged on a back surface of a cell, and a front surface of the cell is not blocked by any metal electrode, which may effectively increase the short-circuit current of the cell and improve the efficiency of the cell. The P-regions and the N-regions on the back surface are alternately arranged, fingers are arranged on the P-regions and the N-regions, and these fingers are connected to busbars of the corresponding polarity. In order to avoid short circuits, a design is typically used where the fingers are connected to the busbars of the same polarity and disconnected at the busbars of different polarities. For example, the positive fingers are disconnected at the negative busbars, and the negative fingers are disconnected at the positive busbars. That is, the fingers have a discontinuous design and are divided into a plurality of finger segments.

In the related art, the fingers of the back-contact solar cell may be formed using an electroplating design. For example, a discontinuous finger metal layer may be arranged in advance in regions where the fingers are required, and then an electroplated layer may be formed by performing electroplating (e.g., copper electroplating) on the finger metal layer using an electroplating device, thereby forming the final fingers.

However, in such a case, since the fingers have a discontinuous design, each finger is divided into a plurality of independent finger segments. In the electroplating process, in order to ensure that all the finger segments have an electroplated layer, it is necessary to sequentially and respectively connect a cathode of the electroplating device to each independent finger segment or sequentially connect the busbars that are connected to and in contact with the finger segments, so that the electroplated layer is plated on all the finger segments. The electroplating process is relatively complex and the electroplating efficiency is relatively low.

### Summary

The present disclosure provides a back-contact solar cell, a cell assembly, and a photovoltaic system, aiming to solve the technical problems of a relatively complex electroplating process and relatively low electroplating efficiency during the electroplating of back electrodes in existing back-contact solar cells.

The present disclosure is implemented as follows: a back-contact solar cell provided by the embodiments of the present disclosure includes a substrate and at least one back electrode structure arranged on a backlight surface of the substrate, and the at least one back electrode structure includes
a plurality of first fingers and a plurality of second fingers sequentially and alternately arranged at intervals in a first direction, where each first finger includes a first finger pre-plated layer which forms an ohmic contact with the substrate and a first finger electroplated layer plated on the first finger pre-plated layer, and each second finger includes a second finger pre-plated layer which forms an ohmic contact with the substrate and a second finger electroplated layer plated on the second finger pre-plated layer;
a plurality of first busbars and a plurality of second busbars sequentially and alternately arranged at intervals in a second direction, where the first direction intersects the second direction, the plurality of first busbars are in contact with first finger pre-plated layers, the plurality of first fingers are disconnected at the plurality of second busbars, the plurality of second busbars are in contact with second finger pre-plated layers, and the second fingers are disconnected at the plurality of first busbars; and
a first conductive connector and a second conductive connector, where the first conductive connector and the second conductive connector are respectively arranged on two ends of each first busbar and two ends of each second busbar, the first conductive connector is connected to ends of all the plurality of first busbars facing away from the second conductive connector, and the second conductive connector is connected to ends of all the plurality of second busbars facing away from the first conductive connector.

In some exemplary embodiments, a width of the first conductive connector is greater than a width of the first finger pre-plated layer, and a width of the second conductive connector is greater than a width of the second finger pre-plated layer.

In some exemplary embodiments, a width of the first finger pre-plated layer is 0.03 mm to 1 mm, and a width of the first conductive connector is 0.1 mm to 10 mm.

In some exemplary embodiments, the width of the first finger pre-plated layer is 0.03 mm to 0.6 mm, and the width of the first conductive connector is 0.1 mm to 5 mm.

In some exemplary embodiments, a width of the second finger pre-plated layer is 0.03 mm to 1 mm, and a width of the second conductive connector is 0.1 mm to 10 mm.

In some exemplary embodiments, the width of the second finger pre-plated layer is 0.03 mm to 0.6 mm, and the width of the second conductive connector is 0.1 mm to 5 mm.

In some exemplary embodiments, both the first conductive connector and the second conductive connector are parallel to the first finger pre-plated layers and the second finger pre-plated layers.

In some exemplary embodiments, at least one of following is satisfied: the first conductive connector forms an ohmic contact with the substrate;
the second conductive connector forms an ohmic contact with the substrate.

In some exemplary embodiments, the backlight surface of the substrate has a plurality of electrode arrangement regions in the first direction, and the back electrode structure is arranged in each electrode arrangement region.

In some exemplary embodiments, in two adjacent back electrode structures, second conductive connectors of the two back electrode structures are adjacent to each other.

In some exemplary embodiments, in the two adjacent back electrode structures, two adjacent second conductive connectors are of an integrally formed structure.

In some exemplary embodiments, in two adjacent back electrode structures, the first conductive connector of one of the back electrode structures is adjacent to the second conductive connector of an other back electrode structure.

In some exemplary embodiments, in two adjacent back electrode structures, the first busbars of one of the back electrode structures are aligned with the first busbars of an other back electrode structure one to one in the first direction, and the second busbars of one of the back electrode structures are aligned with the second busbars of the other back electrode structure one to one in the first direction; or
the first busbars of one of the back electrode structures are aligned with the second busbars of the other back electrode structure one to one in the first direction, and the second busbars of one of the back electrode structures are aligned with the first busbars of the other back electrode structure one to one in the first direction.

In some exemplary embodiments, the first finger pre-plated layer and the second finger pre-plated layer each include a seed layer. The seed layer is formed by a physical vapor deposition method.

In some exemplary embodiments, a composition of the seed layer contains copper, aluminum, or nickel.

In some exemplary embodiments, the first finger pre-plated layer and the second finger pre-plated layer are formed by a light-induced electroplating method or an electroless plating method.

In some exemplary embodiments, a composition of the first finger pre-plated layer and the second finger pre-plated layer contains copper or nickel.

In some exemplary embodiments, each first busbar includes a first busbar pre-plated layer in contact with the first finger pre-plated layer and a first busbar electroplated layer plated on the first busbar pre-plated layer, the first busbar pre-plated layer is in contact with the first conductive connector, and each second busbar includes a second busbar pre-plated layer in contact with the second finger pre-plated layer and a second busbar electroplated layer plated on the second busbar pre-plated layer, the second busbar pre-plated layer is in contact with the second conductive connector.

The present disclosure further provides a cell assembly, including a plurality of any of the back-contact solar cells described above; or a plurality of sliced cells obtained by at least one of cutting and splitting any of the back-contact solar cells described above.

The present disclosure further provides a photovoltaic system, including the above cell assembly.

In the back-contact solar cell, the cell assembly, and the photovoltaic system provided by the embodiments of the present disclosure, through the arrangement of the first conductive connector and the second conductive connector, the first conductive connector may connect the ends of all the first busbars to communicate with the first finger pre-plated layers in contact with the first busbars, and the second conductive connector may connect the ends of all the second busbars to communicate with the second finger pre-plated layers in contact with the second busbars. In this way, when the first finger electroplated layers and the second finger electroplated layers are formed, the first finger electroplated layers may be formed on all the first finger pre-plated layers and the second finger electroplated layers may be formed on all the second finger pre-plated layers respectively by means of simply connecting a cathode of an electroplating device to the first conductive connector and the second conductive connector, without the need to sequentially connect the cathode of the electroplating device to each first busbar and each second busbar, or to each disconnected first finger pre-plated layer and each disconnected second finger pre-plated layer to complete the electroplating process, thereby effectively simplifying the electroplating process and improving the electroplating efficiency.

Additional aspects and advantages of the present disclosure will be partially set forth in the following description, and in part will be apparent from the following description, or may be learned by practice of the present disclosure.

### Brief Description of the Drawings

Fig. 1 is a block diagram of a photovoltaic system according to an embodiment of the present disclosure.
Fig. 2 is a block diagram of a cell assembly according to an embodiment of the present disclosure.
Fig. 3 is a schematic plan view of a back-contact solar cell according to an embodiment of the present disclosure.
Fig. 4 is a schematic cross-sectional view of a back-contact solar cell along line IV-IV in Fig. 3.
Fig. 5 is a schematic plan view of another back-contact solar cell according to an embodiment of the present disclosure.
Fig. 6 is a schematic plan view of still another back-contact solar cell according to an embodiment of the present disclosure.
Fig. 7 is a schematic plan view of yet another back-contact solar cell according to an embodiment of the present disclosure.
Fig. 8 is a schematic plan view of yet another back-contact solar cell according to an embodiment of the present disclosure.
Fig. 9 is a schematic plan view of yet another back-contact solar cell according to an embodiment of the present disclosure.
Fig. 10 is a schematic cross-sectional view of a back-contact solar cell along line X-X in Fig. 3.
Fig. 11 is a schematic cross-sectional view of a back-contact solar cell along line XI-XI in Fig. 3.

Description of main component symbols:
Photovoltaic system 1000; cell assembly 200; Back-contact solar cell 100; Substrate 10; Silicon wafer 11; First polarity doped layer 12; Second polarity doped layer 13; Electrode arrangement region 14; Back electrode structure 20; First finger 21; First finger pre-plated layer 211; First finger electroplated layer 212; Second finger 22; Second finger pre-plated layer 221; Second finger electroplated layer 222; First busbar 23; First busbar pre-plated layer 231; First busbar electroplated layer 232; Second busbar 24; Second busbar pre-plated layer 241; Second busbar electroplated layer 242; First conductive connector 30; Second conductive connector 40; and Passivation film layer 50.

### Detailed Description of the Embodiments

In order to make the objectives, technical solutions and advantages of the present disclosure clearer, the present disclosure will be further described below in detail in conjunction with the accompanying drawings and embodiments. Examples of the embodiments are shown in the accompanying drawings, where the same or similar reference signs throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it is to be understood that the orientations or positional relationships indicated by the terms "upper", "lower", "transverse", "longitudinal", and the like are based on the orientations or positional relationships shown in the accompanying drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In addition, the terms "first" and "second" are used for descriptive purposes only, and cannot be understood as indicating or implying relative importance or implicitly specifying the number of technical features indicated. Therefore, the features defined with "first" and "second" may explicitly or implicitly include one or more features. In the description of the present disclosure, "a plurality of" means two or more, unless explicitly and specifically defined otherwise.

The following disclosure provides various different embodiments or examples for implementing different structures of the present disclosure. In order to simplify the disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art may be aware of the application of other processes and/or usage scenarios of other materials.

In the present disclosure, through the arrangement of a first conductive connector and a second conductive connector, the first conductive connector may connect the ends of all first busbars to communicate with first finger pre-plated layers in contact with the first busbars, and the second conductive connector may connect the ends of all second busbars to communicate with second finger pre-plated layers in contact with the second busbars. In this way, when first finger electroplated layers and second finger electroplated layers are formed, the first finger electroplated layers may be formed on all the first finger pre-plated layers and the second finger electroplated layers may be formed on all the second finger pre-plated layers respectively by means of simply connecting a cathode of an electroplating device to the first conductive connector and the second conductive connector, without the need to sequentially connect the cathode of the electroplating device to each first busbar and each second busbar, or to each disconnected first finger pre-plated layer and each disconnected second finger pre-plated layer to complete the electroplating process, thereby effectively simplifying the electroplating process and improving the electroplating efficiency.

### Embodiment 1

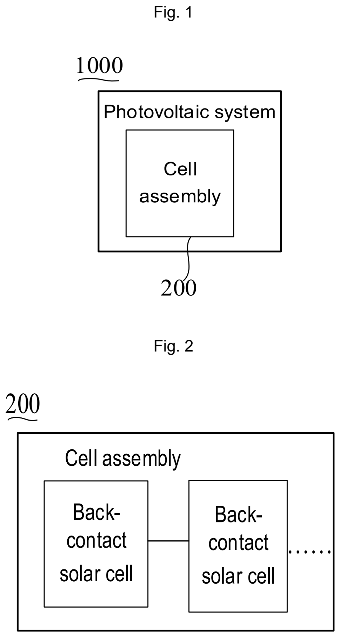

Referring to Fig. 1 to Fig. 2, a photovoltaic system 1000 in the embodiments of the present disclosure may include a cell assembly 200 in the embodiments of the present disclosure, and the cell assembly 200 in the embodiments of the present disclosure may include a plurality of back-contact solar cells 100 in the embodiments of the present disclosure or a plurality of sliced cells obtained by at least one of cutting and splitting the back-contact solar cell 100 in the embodiments of the present disclosure. It is to be noted that the sliced cells may be half-cells, third-cells, quarter-cells, etc., which is not specifically limited herein.

In the cell assembly 200, the plurality of back-contact solar cells 100 or the plurality of sliced cells may be sequentially connected in series to form a plurality of cell strings. The cell strings may be connected in series, in parallel, or in a series-parallel combination to achieve current confluence and output. For example, the connection between the solar cells may be achieved by solder ribbons, and the connection between the cell strings may be achieved by current-collecting busbars.

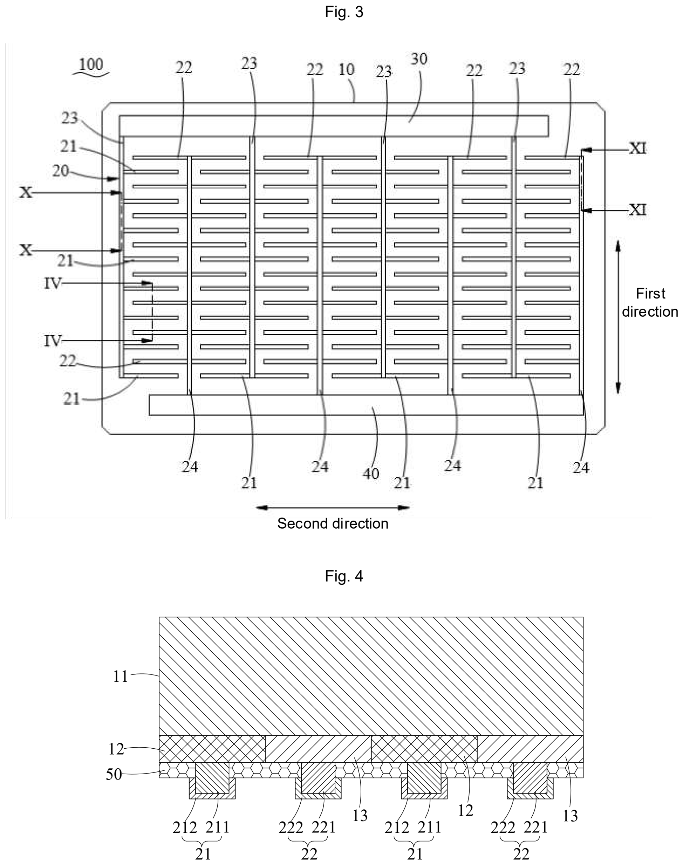

Referring to Fig. 3 and Fig. 4, the back contact solar cell 100 in the embodiments of the present disclosure may include a substrate 10 and at least one back electrode structure 20 arranged on a backlight surface of the substrate 10.

The substrate 10 may include a silicon wafer 11 and first polarity doped layers 12 and second polarity doped layers 13 which are sequentially and alternately arranged on a back surface of the silicon wafer 11. The silicon wafer 11 may be a P-type silicon wafer or an N-type silicon wafer, which is not specifically limited herein. The backlight surface of the substrate 10 is a back surface of the back-contact solar cell 100. The first polarity doped layers 12 and the second polarity doped layers 13 have opposite polarities. For example, the first polarity doped layers 12 may be P-type doped layers and the second polarity doped layers 13 may be N-type doped layers; or the first polarity doped layers 12 may be N-type doped layers and the second polarity doped layer 13 may be P-type doped layers, which is not specifically limited herein.

Referring to Fig. 3, the back electrode structure 20 may include a plurality of first fingers 21, a plurality of second fingers 22, a plurality of first busbars 23, a plurality of second busbars 24, a first conductive connector 30, and a second conductive connector 40.

The plurality of first fingers 21 and the plurality of second fingers 22 may be sequentially and alternately arranged at intervals in a first direction. The plurality of first busbars 23 and the plurality of second busbars 24 may be sequentially and alternately arranged at intervals in a second direction. The first direction intersects the second direction intersect. The first finger 21 may be correspondingly arranged on the first polarity doped layer 12, and the second finger 22 may be correspondingly arranged on the second polarity doped layer 13.

In the embodiments of the present disclosure, the first direction and the second direction may be perpendicular to each other. For example, as shown in Fig. 3, the first direction may be a longitudinal direction of the back-contact solar cell 100, and the second direction may be a transverse direction of the back-contact solar cell 100. The first fingers 21 and the second fingers 22 may be alternately arranged in the longitudinal direction and extend in the transverse direction. The first busbars 23 and the second busbars 24 may be alternately arranged in the transverse direction and extend in the longitudinal direction.

Referring to Fig. 4, each first finger 21 may include a first finger pre-plated layer 211 which forms an ohmic contact with the substrate 10 and a first finger electroplated layer 212 plated on the first finger pre-plated layer 211. Each second finger 22 may include a second finger pre-plated layer 221 which forms an ohmic contact with the substrate 10 and a second finger electroplated layer 222 plated on the second finger pre-plated layer 221. The first busbar 23 is in contact with the first finger pre-plated layer 211, and the first finger 21 is disconnected at the second busbar 24. The second busbar 24 is in contact with the second finger pre-plated layer 221, and the second finger 22 is disconnected at the first busbar 23.

Specifically, the first finger pre-plated layer 211 may form an ohmic contact with the first polarity doped layer 12, and the second finger pre-plated layer 221 may form an ohmic contact with the second polarity doped layer 13. The first finger 21 is configured to collect a current in a region corresponding to the first polarity doped layer 12 on the silicon wafer 11, and the second finger 22 is configured to collect a current in a region corresponding to the second polarity doped layer 13 on the silicon wafer 11. As shown in Fig. X, the first finger 21 is disconnected at the second busbar 24 to form a plurality of finger segments, that is, the second finger 22 is disconnected at the first busbar 23 to form a plurality of finger segments.

It is to be noted that, in the present disclosure, the first polarity doped layer 12 and the second polarity doped layer 13 on the silicon wafer 11 may be formed by deposition, laser doping, metal doping, etc., which is not limited herein. In addition, in the present disclosure, the first polarity doped layer 12 and the second polarity doped layer 13 may or may not be in direct contact, preferably not in direct contact. In such a case, they may be isolated in a physical manner. For example, the first polarity doped layer 12 and the second polarity doped layer 13 may be directly arranged at intervals; or, they may be isolated by means of forming a trench in the silicon wafer 11; or, by means of forming the trench in the silicon wafer 11, one of the first polarity doped layer 12 and the second polarity doped layer 13 may be arranged in the trench to achieve isolation.

Of course, it is understandable that, in some embodiments, the first polarity doped layer 12 and the second polarity doped layer 13 may also be in contact with each other in local regions, or a small portion of the first polarity doped layers 12 among the plurality of first polarity doped layers 12 may be in contact with a small portion of the second polarity doped layers 13 among the plurality of second polarity doped layers 13, which is not specifically limited herein.

Referring to Fig. 3, the first conductive connector 30 and the second conductive connector 40 may be respectively arranged on two ends of each first busbar 23 and two ends of each second busbar 24. As shown in Fig. 3, the first conductive connector 30 and the second conductive connector 40 may be respectively arranged on an upper side and a lower side of each first busbar 23 and each second busbar 24. The first conductive connector 30 is connected to the ends of all the first busbars 23 facing away from the second conductive connector 40. The second conductive connector 40 is connected to the ends of all the second busbars 24 facing away from the first conductive connector 30.

In the back-contact solar cell 100, the cell assembly 200, and the photovoltaic system 1000 provided by the embodiments of the present disclosure, the first busbars 23 are in contact with the first finger pre-plated layers 211, and the second busbars 24 are in contact with the second finger pre-plated layers 221. The first conductive connector 30 and the second conductive connector 40 are respectively arranged on two ends of each first busbar 23 and two ends of each second busbar 24. The first conductive connector 30 is connected to the ends of all the first busbars 23 facing away from the second conductive connector 40, and the second conductive connector 40 is connected to the ends of all the second busbars 24 facing away from the first conductive connector 30. In this way, through the arrangement of the first conductive connector 30 and the second conductive connector 40, the first conductive connector 30 may connect the ends of all the first busbars to communicate with the first finger pre-plated layers 211 in contact with the first busbars 23, and the second conductive connector 40 may connect the ends of all second busbars 24 to communicate with the second finger pre-plated layers 221 in contact with the second busbars 24. In this way, when the first finger electroplated layers 212 and the second finger electroplated layers 222 are formed, the first finger electroplated layers 212 may be formed on all the first finger pre-plated layers 211 and the second finger electroplated layers 222 may be formed on all the second finger pre-plated layers 221 respectively by means of simply connecting a cathode of an electroplating device to the first conductive connector 30 and the second conductive connector 40 respectively, without the need to sequentially connect the cathode of the electroplating device to each first busbar 23 and each second busbar 24, or to each disconnected first finger pre-plated layer 211 and each disconnected second finger pre-plated layer 221 to complete the electroplating process, thereby effectively simplifying the electroplating process and improving the electroplating efficiency.

In the embodiments of the present disclosure, both the first finger electroplated layer 212 and the second finger electroplated layer 222 may be copper electroplated layers. The first conductive connector 30 and the second conductive connector 40 may be metal connectors having a conductive function, and both may be in a regular shape or an irregular shape. For example, in some embodiments, both may be in a linear shape, both may be parallel to the first finger 21 and the second finger 22, or may be obliquely arranged relative to the first finger 21 and the second finger 22. For example, in some embodiments, both may be in other shapes, such as a wavy shape, an arc shape, etc., which is not specifically limited herein.

In addition, referring to Fig. 4, in some embodiments, a passivation film layer 50 may further be arranged on the backlight surface of the substrate 10, and the passivation film layer 50 covers the entire backlight surface. The first finger pre-plated layer 211 penetrates through the passivation film layer 50 to form an ohmic contact with the first polarity doped layer 12, and the second finger pre-plated layer 221 penetrates through the passivation film layer 50 to form an ohmic contact with the second polarity doped layer 13. Furthermore, in some embodiments, a tunneling layer (not shown in the figure) may further be arranged between the back surface of the silicon wafer 11 and the first polarity doped layer 12 and the second polarity doped layer 13.

It is understandable that, in the embodiments of the present disclosure, the cell assembly 200 may further include a metal frame, a backsheet, photovoltaic glass, and an adhesive film (not shown in the figure). The adhesive film may be filled between a front surface of the back-contact solar cell 100 and the photovoltaic glass, between the back surface and the backsheet, between the adjacent cells, and the like as a filler, the adhesive film may be a transparent colloid with good light transmittance and aging resistance. For example, the adhesive film may be an EVA adhesive film or a POE adhesive film, which may be selected according to the actual situation, and is not limited herein.

The photovoltaic glass may cover the adhesive film on the front surface of the back-contact solar cell 100. The photovoltaic glass may be ultra-white glass having high light transmittance, high transparency, and superior physical, mechanical, and optical properties, for example, the light transmittance of the ultra-white glass may reach 92% or more, which may protect the back-contact solar cell 100 without affecting the efficiency of the back-contact solar cell 100 as much as possible. At the same time, the adhesive film may adheres the photovoltaic glass and the back-contact solar cell 100 together, and the presence of the adhesive film may provide sealing, insulation, and waterproof and moisture-proof protection for the back-contact solar cell 100.

The backsheet may be attached to the adhesive film on the back surface of the back-contact solar cell 100, the backsheet may protect and support the back-contact solar cell 100, and has reliable insulation, water resistance and aging resistance. The backsheet may have multiple choices, usually tempered glass, organic glass, aluminum alloy TPT composite adhesive film, etc., which may be specifically set according to the specific situation, and is not limited herein. The whole composed of the backsheet, the back-contact solar cell 100, the adhesive film, and the photovoltaic glass may be arranged on the metal frame, and the metal frame serves as a main external support structure of the entire cell assembly 200, and may stably support and install the cell assembly 200, for example, the cell assembly 200 may be installed at a desired installation position through the metal frame.

Further, in the present embodiment, the photovoltaic system 1000 may be applied to photovoltaic power stations, such as ground power stations, rooftop power stations, or water surface power stations, and may also be applied to devices or apparatuses that use solar energy for power generation, such as user solar power sources, solar street lights, solar cars, or solar buildings. Of course, it is understandable that, the application scenarios of the photovoltaic system 1000 are not limited to this, that is, the photovoltaic system 1000 may be applied in all fields where solar power generation is required. Taking a photovoltaic power generation system network as an example, the photovoltaic system 1000 may include a photovoltaic array, a combiner box, and an inverter. The photovoltaic array may be an array combination of a plurality of cell assemblies 200. For example, the plurality of cell assemblies 200 may form a plurality of photovoltaic arrays, and the photovoltaic arrays are connected to the combiner box. The combiner box may combine current generated by the photovoltaic array, and the combined current flows through the inverter to be converted into alternating current required by a mains power grid and then connected to the mains power network to achieve solar power supply.

In some embodiments, the first finger pre-plated layer 211 and the second finger pre-plated layer 221 each may include a seed layer. The seed layer is formed by a physical vapor deposition method. In this way, a stable ohmic contact may be formed between the seed layer and the first polarity doped layer 12 and the second polarity doped layer 13.

Specifically, the material of the seed layer may be a metal material, preferably an alloy material. In some embodiments, a primary component of the seed layer may contain copper or aluminum or nickel.

In some embodiments, the seed layer may include a primary component and a reinforcement component. The primary component may contain any one or more metals such as aluminum, silver, copper, and magnesium. The reinforcement component may contain any one or more metals such as molybdenum, titanium, tungsten, and nickel. Of course, in some possible embodiments, the seed layer may also be a single metal layer, as long as it can enable a subsequent electroplating function, which is not specifically limited herein.

In such an embodiment, the passivation film layer 50 may first be deposited on the substrate 10. Then, openings may be formed in regions corresponding to the first finger pre-plated layer 211 and the second finger pre-plated layer 221 on the passivation film layer 50. Subsequently, the seed layer may be deposited in each opening by a physical vapor deposition method, thereby forming the first finger pre-plated layer 211 and the second finger pre-plated layer 221, which respectively form an ohmic contact with the first polarity doped layer 12 and the second polarity doped layer 13.

In addition, in some embodiments, the first finger pre-plated layer 211 and the second finger pre-plated layer 221 may also be formed by a light-induced electroplating method or an electroless plating method, which is not specifically limited herein. In such a case, the composition of the first finger pre-plated layer 211 and the second finger pre-plated layer 221 may contain copper or nickel.

### Embodiment 2

Referring to Fig. 3, in some embodiments, a width of the first conductive connector 30 is greater than a width of the first finger pre-plated layer 211, and a width of the second conductive connector 40 is greater than a width of the second finger pre-plated layer 221.

In this way, by setting the widths of the first conductive connector 30 and the second conductive connector 40 to be relatively large, the connection between the first conductive connector 30 and the cathode of the electroplating device, and between the second conductive connector 40 and the cathode of the electroplating device may be facilitated, thereby ensuring the reliability of electroplating.

At the same time, since the first conductive connector 30 connects all the first busbars 23 together and the second conductive connector 40 connects all the second busbars 24 together, the first conductive connector 30 and the second conductive connector 40 require a higher current-carrying capacity than the first finger pre-plated layer 211 and the second finger pre-plated layer 221, so as to prevent fusing caused by the overcurrent of the first conductive connector 30 and the second conductive connector 40. Therefore, by setting the widths of the first conductive connector 30 and the second conductive connector 40 to be relatively large, the reliability of the back-contact solar cell 100 may also be ensured.

It is to be noted that, herein, "width" refers to the dimension of each component in the first direction (i.e., the longitudinal direction). Any identical descriptions hereinafter may be understood with reference to this definition.

### Embodiment 3

In some embodiments, the width of the first finger pre-plated layer 211 may be 0.03 mm to 1 mm, and the width of the first conductive connector 30 may be 0.1 mm to 10 mm.

In this way, by setting the width of the first finger pre-plated layer 211 within a reasonable range of 0.03 mm to 1 mm, a reliable ohmic contact between the first finger pre-plated layer 211 and the substrate 10 may be formed and the electroplating effect may be ensured. By setting the width of the first conductive connector 30 within a reasonable range of 0.1 mm to 10 mm, both the reliability of connection between the first conductive connector 30 and the cathode of the electroplating device and the current-carrying capacity of the first conductive connector 30 may be ensured, thereby improving the reliability of the back-contact solar cell 100.

Specifically, in such an embodiment, the width of the first finger pre-plated layer 211 may, for example, be 0.03 mm, 0.04 mm, 0.05 mm, 0.06 mm, 0.07 mm, 0.08 mm, 0.09 mm, 0.1 mm, 0.2 mm, 0.3 mm, 0.4 mm, 0.5 mm, 0.6 mm, 0.7 mm, 0.8 mm, 0.9 mm, 1 mm, or any value between 0.03 mm and 1 mm, which is not specifically limited herein.

The width of the first conductive connector 30 may, for example, be 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, 6 mm, 7 mm, 8 mm, 9 mm, 10 mm, or any value between 0.1 mm and 10 mm, which is not specifically limited herein.

Further, in such an embodiment, the width of the first finger pre-plated layer 211 may preferably be 0.03 mm to 0.6 mm, and the width of the first conductive connector 30 may preferably be 0.1 mm to 5 mm.

Specifically, the inventors of the present disclosure have verified and found through research that if the width of the first finger pre-plated layer 211 is less than 0.03 mm, it may easily lead to unstable ohmic contact between the first finger pre-plated layer 211 and the substrate 10 and also affect the subsequent electroplating effect. If the width of the first finger pre-plated layer 211 is greater than 0.6 mm, it may result in a substantial increase in cost. Therefore, by setting the width of the first finger pre-plated layer 211 within a preferred range of 0.03 mm to 0.6 mm, the contact reliability and the electroplating effect may be ensured and costs may be effectively reduced.

In addition, the inventors of the present disclosure have also verified and found through research that if the width of the first conductive connector 30 is less than 0.1 mm, it may easily lead to poor contact between the first conductive connector 30 and an electrode during the electroplating process, and after the electroplating is subsequently completed, the first conductive connector 30 is also prone to overcurrent, leading to fusing, thereby reducing the reliability of the back-contact solar cell 100. If the width of the first conductive connector 30 is greater than 5 mm, it may result in a substantial increase in cost. Therefore, by setting the width of the first conductive connector 30 within a preferred range of 0.1 mm to 5 mm, the reliability of electroplating and the reliability of the back-contact solar cell 100 may be ensured and costs may be effectively controlled.

### Embodiment 4

In some embodiments, a width of the second finger pre-plated layer 221 may be 0.03 mm to 1 mm, and a width of the second conductive connector 40 may be 0.1 mm to 10 mm.

In this way, by setting the width of the second finger pre-plated layer 221 within a reasonable range of 0.03 mm to 1 mm, a reliable ohmic contact between the second finger pre-plated layer 221and the substrate 10 may be formed and the electroplating effect may be ensured. By setting the width of the second conductive connector 40 within a reasonable range of 0.1 mm to 10 mm, both the reliability of connection between the second conductive connector 40 and the cathode of the electroplating device and the current-carrying capacity of the second conductive connector 40 may be ensured, thereby improving the reliability of the back-contact solar cell 100.

Specifically, in such an embodiment, the width of the second finger pre-plated layer 221 may, for example, be 0.03 mm, 0.04 mm, 0.05 mm, 0.06 mm, 0.07 mm, 0.08 mm, 0.09 mm, 0.1 mm, 0.2 mm, 0.3 mm, 0.4 mm, 0.5 mm, 0.6 mm, 0.7 mm, 0.8 mm, 0.9 mm, 1 mm, or any value between 0.03 mm and 1 mm, which is not specifically limited herein.

The width of the second conductive connector 40 may, for example, be 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, 6 mm, 7 mm, 8 mm, 9 mm, 10 mm, or any value between 0.1 mm and 10 mm, which is not specifically limited herein.

Further, in such an embodiment, the width of the second finger pre-plated layer 221 may preferably be 0.03 mm to 0.6 mm, and the width of the second conductive connector 40 may preferably be 0.1 mm to 5 mm.

Specifically, the inventors of the present disclosure have verified and found through research that if the width of the second finger pre-plated layer 221 is less than 0.03 mm, it may easily lead to unstable ohmic contact between the second finger pre-plated layer 221 and the substrate 10 and also affect the subsequent electroplating effect. If the width of the second finger pre-plated layer 221 is greater than 0.6 mm, it may result in a substantial increase in cost. Therefore, by setting the width of the second finger pre-plated layer 221 within a preferred range of 0.03 mm to 0.6 mm, the contact reliability and the electroplating effect may be ensured and costs may be effectively reduced.

In addition, the inventors of the present disclosure have also verified and found through research that if the width of the second conductive connector 40 is less than 0.1 mm, it may easily lead to poor contact between the second conductive connector 40 and the electrode during the electroplating process, and after the electroplating is subsequently completed, the second conductive connector 40 is also prone to overcurrent, leading to fusing, thereby reducing the reliability of the back-contact solar cell 100. If the width of the second conductive connector 40 is greater than 5 mm, it may result in a substantial increase in cost. Therefore, by setting the width of the second conductive connector 40 within a preferred range of 0.1 mm to 5 mm, the reliability of electroplating and the reliability of the back-contact solar cell 100 may be ensured and costs may be effectively controlled.

### Embodiment 5

Referring to Fig. 3, in some embodiments, both the first conductive connector 30 and the second conductive connector 40 are parallel to the first finger pre-plated layers 211 and the second finger pre-plated layers 221. Such arrangement may avoid the oblique arrangement of the first conductive connector 30 and the second conductive connector 40, which may result in excessive space occupation, and thus resulting in an increase in the size of the back-contact solar cell 100.

### Embodiment 6

In some embodiments, the first conductive connector 30 may form an ohmic contact with the substrate 10. Specifically, the first polarity doped layer 12 may be arranged in a region corresponding to the first conductive connector 30. The first conductive connector 30 may penetrate through the passivation film layer 50 to form an ohmic contact with the first polarity doped layer 12 corresponding to the first conductive connector 30.

In this way, the first conductive connector 30 may achieve a function of collecting carriers in the silicon wafer **11** while connecting the first busbars 23, thereby effectively improving the efficiency.

Similarly, in some embodiments, the second conductive connector 40 may also form an ohmic contact with the substrate 10. Specifically, the second polarity doped layer 13 may be arranged in a region corresponding to the second conductive connector 40. The second conductive connector 40 may penetrate through the passivation film layer 50 to form an ohmic contact with the second polarity doped layer 13 corresponding to the second conductive connector 40.

In this way, the second conductive connector 40 may achieve the function of collecting the carriers in the silicon wafer 11 while connecting the second busbars 24, thereby effectively improving the efficiency.

Of course, it is understandable that, in other embodiments, the first conductive connector 30 may not be in contact with the substrate 10, but may be connected to the first busbars 23 and suspended above the substrate 10. Similarly, in some embodiments, the second conductive connector 40 may not be in contact with the silicon wafer 11, but may be connected to the second busbars 24 and suspended above the substrate 10. In such a case, the first conductive connector 30 and the second conductive connector 40 may be directly suspended or arranged on the passivation film layer 50 without penetrating through the passivation film layer 50.

### Embodiment 7

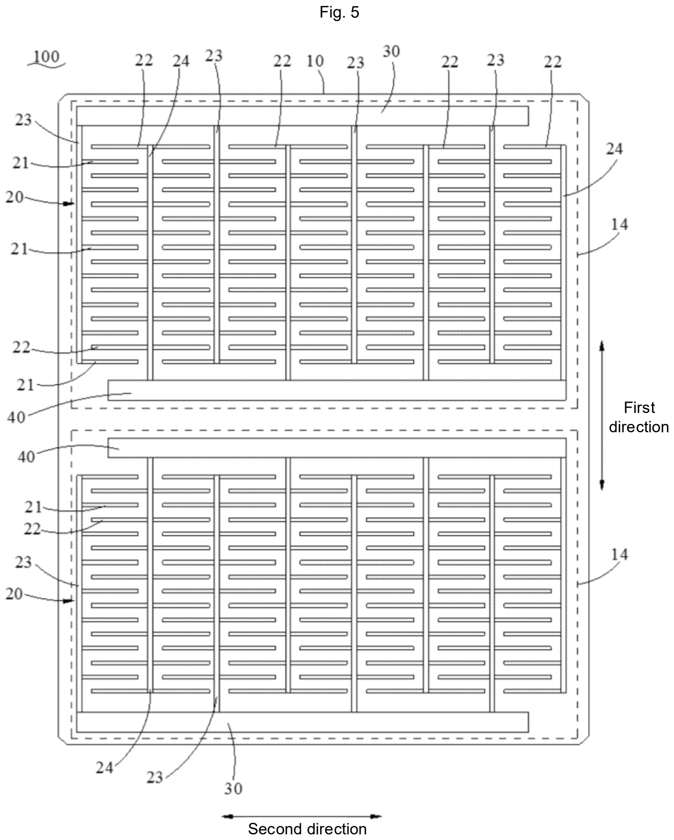

Referring to Fig. 5 to Fig. 9, the backlight surface of the substrate 10 may have a plurality of electrode arrangement regions 14 in the first direction, and the back electrode structure 20 is arranged in each electrode arrangement region 14.

In this way, the backlight surface of the substrate 10 is divided into the plurality of electrode arrangement regions 14, and the back electrode structure 20 is arranged in each region. Subsequently, the back-contact solar cell 100 may be at least one of cut and split to segment the back-contact solar cell 100 into the plurality of sliced cells, that is, the first finger pre-plated layers 211 and the second finger pre-plated layers 221 in all the electrode arrangement regions 14 may be electroplated by one electroplating process, and then segmented to obtain the sliced cells.

Specifically, as shown in Fig. 5 to Fig. 8, in the embodiments shown in Fig. 5 to Fig. 8, the back-contact solar cell 100 may have two electrode arrangement regions 14. At this time, two sliced cells may be obtained after segmentation.

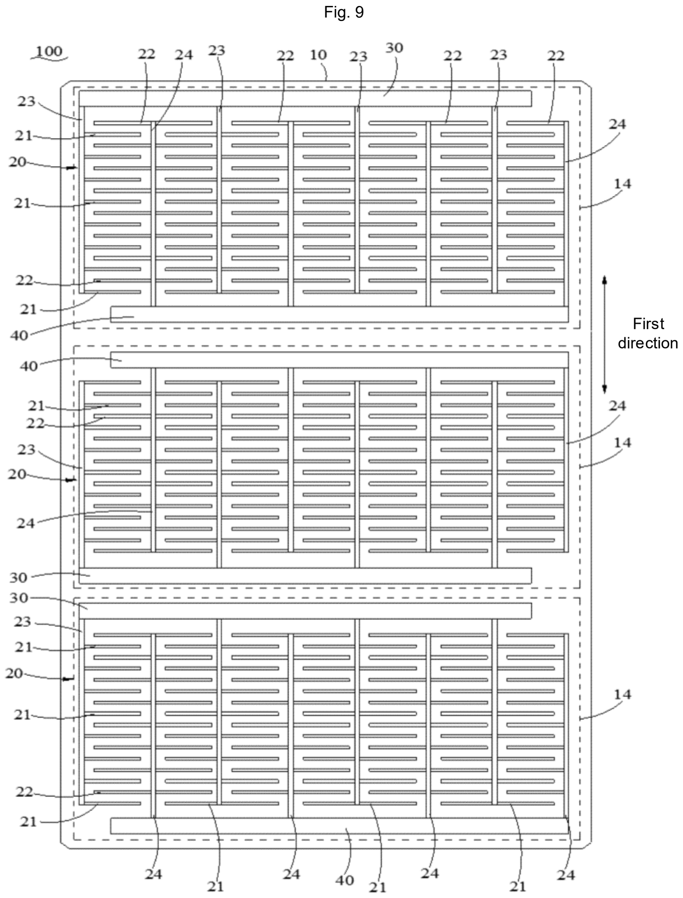

In the embodiment shown in Fig. 9, the back-contact solar cell 100 may have three electrode arrangement regions 14. At this time, three sliced cells may be obtained after segmentation. Of course, the back-contact solar cell 100 may also have three or more electrode arrangement regions 14, so that more sliced cells may be obtained after segmentation, that is, when the number of electrode arrangement regions 14 is N (N is a positive integer greater than 1), N sliced cells may be obtained after segmentation.

### Embodiment 8

Referring to Fig. 5, in some embodiments, in the two adjacent back electrode structures 20, the second conductive connectors 40 in the two back electrode structures 20 are adjacent to each other.

In this way, the second conductive connectors 40 of the two adjacent back electrode structures 20 are adjacent to each other. When the segmentation of the sliced cells is required, the sliced cells may be obtained by segmentation along an interval between the two second conductive connectors 40. After the segmentation is completed, the sliced cells may be connected by solder ribbons to form a cell string. When the segmentation of the sliced cells is not required, the two adjacent second conductive connectors 40 are directly connected through solder ribbons or current-collecting busbars to communicate the adjacent back electrode structures 20.

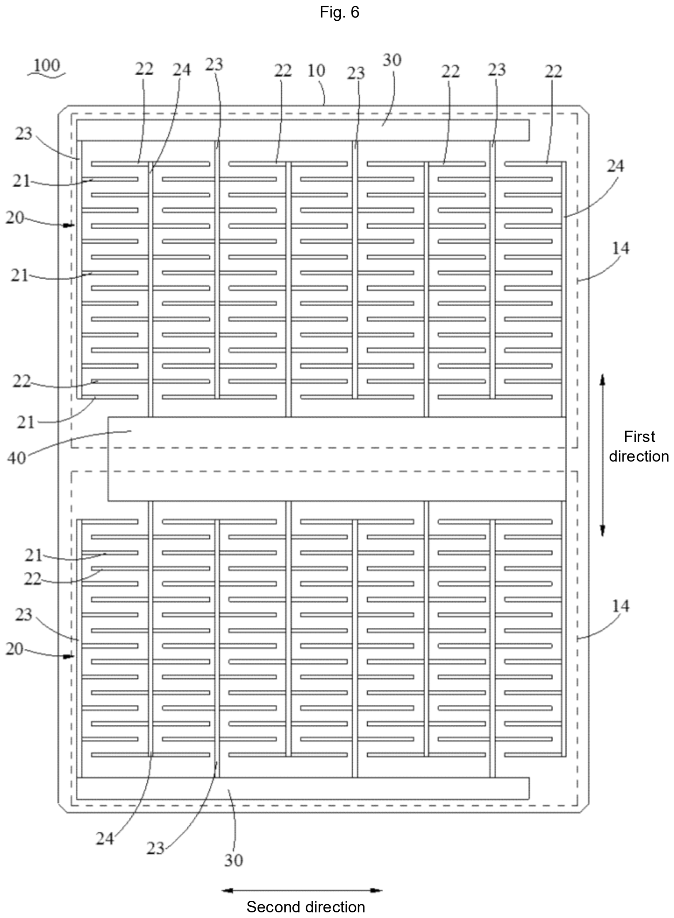

Further, referring to Fig. 6, in such an embodiment, when the segmentation of the back-contact solar cell 100 is not required, the two adjacent second conductive connectors 40 may be of an integrally formed structure, that is, the two adjacent back electrode structures 20 share one second conductive connector 40.

### Embodiment 9

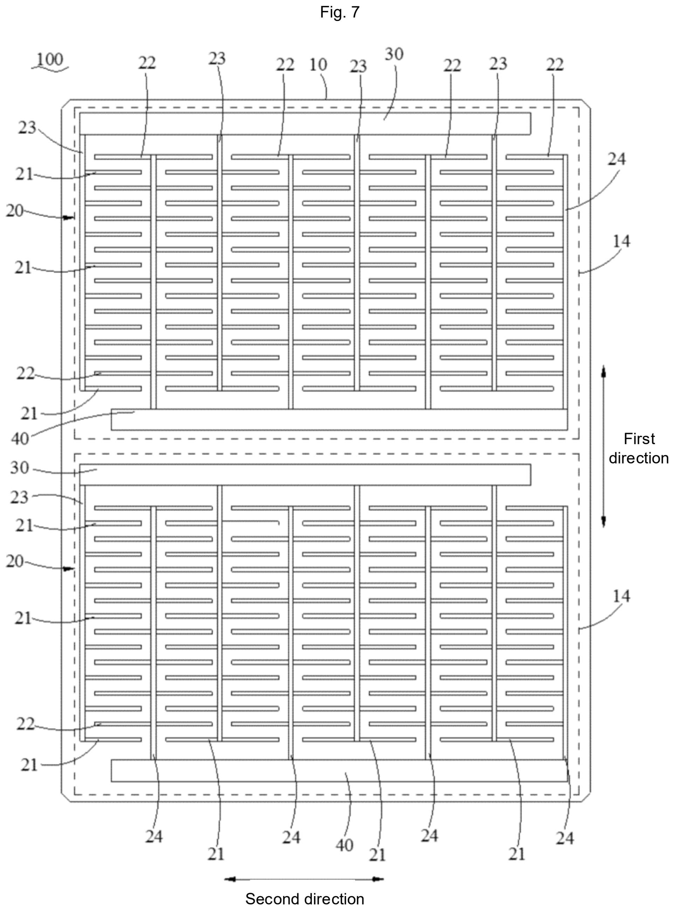

Referring to Fig. 7, in some embodiments, in the two adjacent back electrode structures 20, the first conductive connector 30 of one of the back electrode structures 20 is adjacent to the second conductive connector 40 of the other back electrode structure 20.

In this way, in the two adjacent back electrode structures 20, the first conductive connector 30 and the second conductive connector 40 are adjacent to each other. In such a case, the sliced cells are formed by segmentation along an interval between the first conductive connector 30 and the second conductive connector 40, and then connected to obtain a cell string.

It is to be noted that, when the back-contact solar cell 100 has only two electrode arrangement regions 14, the arrangement may follow the arrangement of Embodiment 8 or Embodiment 9.

When the back-contact solar cell 100 has two or more electrode arrangement regions 14, some of the two adjacent back electrode structures 20 may be arranged in the manner of Embodiment 8, and other two adjacent back electrode structures 20 may be arranged in the manner of Embodiment 9.

For example, when the number of electrode arrangement regions 14 is three, as shown in Fig. 9, the second conductive connector 40 of the first back electrode structure 20 from top to bottom may be adjacent to the second conductive connector 40 of the second back electrode structure 20, while the first conductive connector 30 of the third back electrode structure 20 may be adjacent to the first conductive connector 30 of the second back electrode structure 20.

Of course, it is understandable that the arrangement may also be such that the second conductive connector 40 of the first back electrode structure 20 from top to bottom is adjacent to the first conductive connector 30 of the second back electrode structure 20, and the second conductive connector 40 of the third back electrode structure 20 is adjacent to the first conductive connector 30 of the second back electrode structure 20. In the present disclosure, the arrangement of the plurality of back electrode structures 20 is not limited. Of course, in order to facilitate the consistency of production, the arrangement described in Embodiment 8 or Embodiment 9 may be preferably adopted.

### Embodiment 10

Referring to Fig. 5 to Fig. 7, in some embodiments, in the two adjacent back electrode structures 20, the first busbars 23 of one of the back electrode structures 20 are aligned with the first busbars 23 of the other back electrode structure 20 one to one in the first direction, and the second busbars 24 of one of the back electrode structures 20 are aligned with the second busbars 24 of the other back electrode structure 20 one to one in the first direction.

In this way, since the first busbars 23 of the two adjacent back electrode structures 20 are aligned and the second busbars 24 of the two adjacent back electrode structures 20 are also aligned, after the back-contact solar cell 100 is segmented into the sliced cells, some of the sliced cells may be rotated by 180 degrees, so that the busbars of the same polarity between the sliced cells are aligned for the subsequent soldering process to form a cell string.

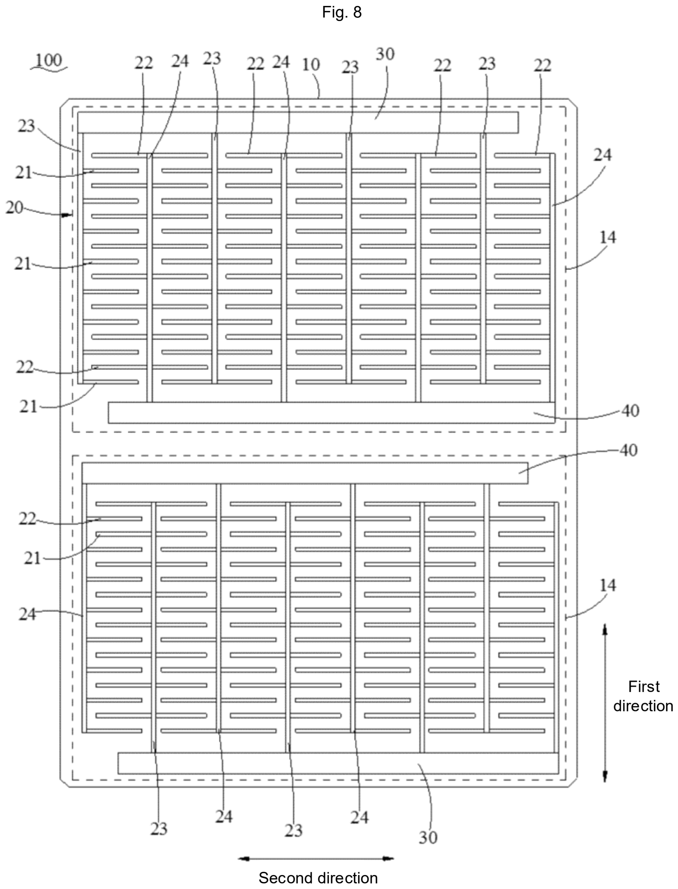

In addition, referring to Fig. 8, in some embodiments, in the two adjacent back electrode structures 20, the first busbars 23 of one of the back electrode structures 20 are aligned with the second busbars 24 of the other back electrode structure 20 one to one in the first direction, and the second busbars 24 of one of the back electrode structures 20 are aligned with the first busbars 23 of the other back electrode structure 20 one to one in the first direction.

In this way, since the first busbars 23 and the second busbars 24 of the two adjacent back electrode structures 20 are aligned, after the back-contact solar cell 100 is segmented into the sliced cells, a cell string may be directly formed by connecting the first busbars 23 and the second busbars 24 of the two adjacent sliced cells through solder ribbons, without the need to rotate the sliced cells, thereby eliminating the process of rotating the sliced cells, saving costs and improving the production efficiency.

It is understandable that, in the embodiments of the present disclosure, solder joints may be arranged on both the first busbars 23 and the second busbars 24 for soldering the solder ribbons.

### Embodiment 11

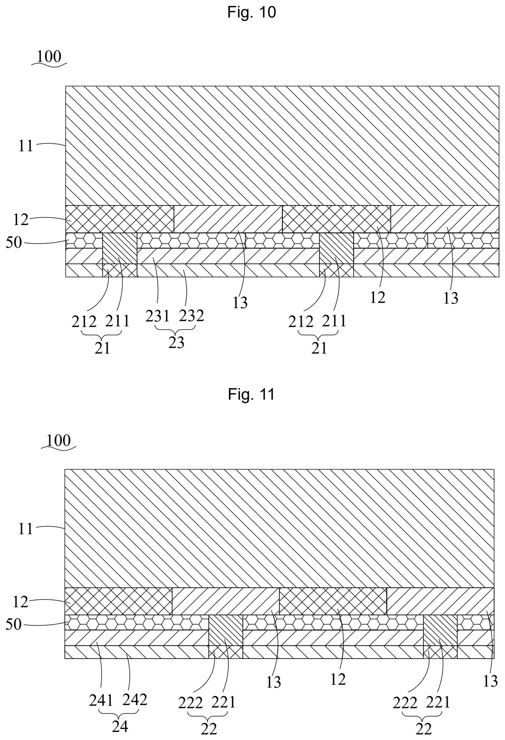

Referring to Fig. 10 and Fig. 11, in some embodiments, the first busbar 23 may include a first busbar pre-plated layer 231 in contact with the first finger pre-plated layer 211 and a first busbar electroplated layer 232 plated on the first busbar pre-plated layer 231, and the first busbar pre-plated layer 231 is in contact with the first conductive connector 30. The second busbar 24 includes a second busbar pre-plated layer 241 in contact with the second finger pre-plated layer 221 and a second busbar electroplated layer 242 plated on the second busbar pre-plated layer 241, and the second busbar pre-plated layer 241 is in contact with the second conductive connector 40.

In this way, the first conductive connector 30 may connect all the first busbar pre-plated layers 231 together, and the second conductive connector 40 may connect all the second busbar pre-plated layers 241 together. When the first busbar electroplated layers 232 and the second busbar electroplated layers 242 are formed, the electroplated layers may be plated on the first finger pre-plated layers 211, the second finger pre-plated layers 221, the first busbar pre-plated layers 231, and the second busbar pre-plated layers 241 at the same time by simply connecting the cathode of the electroplating device to the first conductive connector 30 and the second conductive connector 40, without the need for sequential electroplating, thereby simplifying the electroplating process and improving the electroplating efficiency.

Specifically, in such an embodiment, both the first busbar electroplated layer 232 and the second busbar electroplated layer 242 may also be copper electroplated layers. Like the first finger pre-plated layer 211 and the second finger pre-plated layer 221, in some embodiments, the first busbar pre-plated layer 231 and the second busbar pre-plated layer 241 may each include a seed layer, and the seed layer may be formed by a physical vapor deposition method. In this way, a stable ohmic contact with the first polarity doped layer 12 and the second polarity doped layer 13 may be formed through the seed layer.

Specifically, the seed layer may be a metal material, preferably an alloy material. In some embodiments, a primary component of the seed layer may contain copper or aluminum or nickel.

It is understandable that, in some embodiments, the seed layer may include a primary component and a reinforcement component. The primary component may be one or more of aluminum, silver, copper, and magnesium. The reinforcement component may include one or more metals such as molybdenum, titanium, tungsten, and nickel. Of course, in some possible embodiments, the seed layer may also be a single metal layer, as long as it can enable a subsequent electroplating function, which is not specifically limited herein.

In such an embodiment, the passivation film layer 50 may first be deposited on the substrate 10. Then, openings may be formed in regions corresponding to the first busbar pre-plated layer 231 and the second busbar pre-plated layer 241 on the passivation film layer 50. Subsequently, a seed layer may be deposited in each opening by a physical vapor deposition method, thereby causing the first busbar pre-plated layer 231 to form an ohmic contact with the first polarity doped layer 12 and causing the second busbar pre-plated layer 241 to form an ohmic contact with the second polarity doped layer 13, respectively.

In addition, in some embodiments, the first busbar pre-plated layer 231 and the second busbar pre-plated layer 241 may also be formed by a light-induced electroplating method or an electroless plating method, which is not specifically limited herein. In such a case, the composition of the first busbar pre-plated layer 231 and the second busbar pre-plated layer 241 may contain copper or nickel.

In the description of the present specification, descriptions of the reference terms "some embodiments", "an exemplary embodiment", "an example", "a specific example", "some examples", or the like mean that specific features, structures, materials, or characteristics described in combination with the embodiment or the example are included in at least one embodiment or example of the present disclosure. In this specification, schematic representations of the above terms do not necessarily refer to the same embodiment or example. Furthermore, the specific features, structures, materials, or characteristics described may be combined in any suitable manner in any one or more embodiments or examples.

In addition, the above are merely preferred embodiments of the present disclosure, but are not intended to limit the present disclosure. Any modification, equivalent replacement, improvement, or the like made within the spirit and principle of the present disclosure shall fall within the scope of protection of the present disclosure.

## Claims

1. A back-contact solar cell, comprising a substrate and at least one back electrode structure arranged on a backlight surface of the substrate, wherein the at least one back electrode structure comprises:
a plurality of first fingers and a plurality of second fingers sequentially and alternately arranged at intervals in a first direction, wherein each first finger comprises a first finger pre-plated layer which forms an ohmic contact with the substrate and a first finger electroplated layer plated on the first finger pre-plated layer, and each second finger comprises a second finger pre-plated layer which forms an ohmic contact with the substrate and a second finger electroplated layer plated on the second finger pre-plated layer;
a plurality of first busbars and a plurality of second busbars sequentially and alternately arranged at intervals in a second direction, wherein the first direction intersects the second direction, the plurality of first busbars are in contact with first finger pre-plated layers, the plurality of first fingers are disconnected at the plurality of second busbars, the plurality of second busbars are in contact with second finger pre-plated layers, and the second fingers are disconnected at the plurality of first busbars; and
a first conductive connector and a second conductive connector, wherein the first conductive connector and the second conductive connector are respectively arranged on two ends of each first busbar and two ends of each second busbar, the first conductive connector is connected to ends of all the plurality of first busbars facing away from the second conductive connector, and the second conductive connector is connected to ends of all the plurality of second busbars facing away from the first conductive connector.

2. The back-contact solar cell according to claim 1, wherein a width of the first conductive connector is greater than a width of the first finger pre-plated layer, and a width of the second conductive connector is greater than a width of the second finger pre-plated layer.

3. The back-contact solar cell according to claim 1, wherein a width of the first finger pre-plated layer is 0.03 mm to 1 mm, and a width of the first conductive connector is 0.1 mm to 10 mm.

4. The back-contact solar cell according to claim 3, wherein the width of the first finger pre-plated layer is 0.03 mm to 0.6 mm, and the width of the first conductive connector is 0.1 mm to 5 mm.

5. The back-contact solar cell according to claim 1, wherein a width of the second finger pre-plated layer is 0.03 mm to 1 mm, and a width of the second conductive connector is 0.1 mm to 10 mm.

6. The back-contact solar cell according to claim 5, wherein the width of the second finger pre-plated layer is 0.03 mm to 0.6 mm, and the width of the second conductive connector is 0.1 mm to 5 mm.

7. The back-contact solar cell according to claim 1, wherein both the first conductive connector and the second conductive connector are parallel to the first finger pre-plated layers and the second finger pre-plated layers.

8. The back-contact solar cell according to claim 1, wherein at least one of following is satisfied:
the first conductive connector forms an ohmic contact with the substrate;
the second conductive connector forms an ohmic contact with the substrate.

9. The back-contact solar cell according to any one of claims 1 to 8, wherein the backlight surface of the substrate has a plurality of electrode arrangement regions in the first direction, and the back electrode structure is arranged in each electrode arrangement region.

10. The back-contact solar cell according to claim 9, wherein in two adjacent back electrode structures, second conductive connectors of the two back electrode structures are adjacent to each other.

11. The back-contact solar cell according to claim 10, wherein, in the two adjacent back electrode structures, two adjacent second conductive connectors are of an integrally formed structure.

12. The back-contact solar cell according to claim 9, wherein in two adjacent back electrode structures, the first conductive connector of one of the back electrode structures is adjacent to the second conductive connector of an other back electrode structure.

13. The back-contact solar cell according to claim 9, wherein, in two adjacent back electrode structures, the first busbars of one of the back electrode structures are aligned with the first busbars of an other back electrode structure one to one in the first direction, and the second busbars of one of the back electrode structures are aligned with the second busbars of the other back electrode structure one to one in the first direction; or
the first busbars of one of the back electrode structures are aligned with the second busbars of the other back electrode structure one to one in the first direction, and the second busbars of one of the back electrode structures are aligned with the first busbars of the other back electrode structure one to one in the first direction.

14. The back-contact solar cell according to claim 1, wherein the first finger pre-plated layer and the second finger pre-plated layer each comprise a seed layer, wherein the seed layer is formed by a physical vapor deposition method.

15. The back-contact solar cell according to claim 14, wherein a composition of the seed layer contains copper, aluminum, or nickel.

16. The back-contact solar cell according to claim 1, wherein the first finger pre-plated layer and the second finger pre-plated layer are formed by a light-induced electroplating method or an electroless plating method.

17. The back-contact solar cell according to claim 16, wherein a composition of the first finger pre-plated layer and the second finger pre-plated layer contains copper or nickel.

18. The back-contact solar cell according to claim 1, wherein each first busbar comprises a first busbar pre-plated layer in contact with the first finger pre-plated layer and a first busbar electroplated layer plated on the first busbar pre-plated layer, the first busbar pre-plated layer is in contact with the first conductive connector; and each second busbar comprises a second busbar pre-plated layer in contact with the second finger pre-plated layer and a second busbar electroplated layer plated on the second busbar pre-plated layer, the second busbar pre-plated layer is in contact with the second conductive connector.

19. A cell assembly, comprising a plurality of back-contact solar cells according to any one of claims 1 to 18; or a plurality of sliced cells obtained by at least one of cutting and splitting the back-contact solar cell according to any one of claims 1 to 18.

20. A photovoltaic system, comprising the cell assembly according to claim 19.
